# EUROPEAN PATENT SPECIFICATION

(11) **EP 1 443 126 B1**
(45) Date of publication and mention of the grant of the patent: **07.05.2008**
(21) Application number: 02765557.0
(22) Date of filing: 13.09.2002
(51) Int. Cl.: C23C 14/24, C01B 33/113

(54) **SILICON MONOXIDE VAPOR DEPOSITION MATERIAL AND METHOD FOR PREPARATION THEREOF**
MATERIAL ZUR DAMPFABSCHEIDUNG VON SILICIUMMONOXID UND HERSTELLUNGSVERFAHREN DAFÜR
MATERIAU DE MONOXYDE DE SILICIUM POUR DEPOT PAR EVAPORATION SOUS VIDE ET PROCEDE DE PREPARATION DE CELUI-CI

(30) Priority: 17.09.2001 JP 2001281524
(43) Date of publication of application: 04.08.2004
(73) Proprietor: OSAKA Titanium Technologies Co., Ltd., Amagasaki-shi, Hyogo 660-8533 (JP)
(72) Inventor: NISHIOKA, Kazuo, Itami-shi, Hyogo 664-0027 (JP)
(74) Representative: Butler, Lance
(86) International application number: PCT/JP2002/009472
(87) International publication number: WO 2003/025246

(56) References cited:
- EP-A2- 0 216 649
- JP-A- 5 171 412
- JP-A- 9 110 412
- JP-A- 2001 220 122
- JP-A- 2001 226 113
- JP-B1- 40 022 050
- JP-B2- 4 081 524

## Description

### TECHNICAL FIELD

The present invention relates to a silicon monoxide vapor deposition material which is used to manufacture a silicon oxide vapor deposition film that has superior gas barrier properties as a packaging material for food products, medical products, drugs and the like, and a method for the preparation thereof.

### BACKGROUND ART

In the field of food product packaging, it is necessary to prevent the deterioration of fats and proteins contained in the packaging, i. e., to suppress deterioration in the quality of of the product due to oxidation that might be caused by oxygen, water vapor, aromatic gases and the like that pass through the packaging material.

Furthermore, in the case of medical products and drugs, an even higher level of suppression of any degeneration or deterioration of the contents is required.

Accordingly, materials which have high gas barrier properties against oxygen, water vapor, aromatic gases and the like that cause deterioration of the contents are required as packaging materials for food products, medical products, drugs and the like.

Such packaging materials that have high gas barrier properties include vapor deposition films in which silicon oxides are deposited by vapor deposition on a macromolecular film. In particular, silicon monoxide vapor deposition films, which have superior gas barrier properties against oxygen, water vapor, aromatic gases and the like, have attracted attention.

In regard to the silicon monoxide vapor deposition material that is the raw material used to form such silicon monoxide vapor deposition films, a raw material comprising a mixture of powdered silicon and powdered silicon dioxide is sublimated in a vacuum atmosphere at a high temperature, and the silicon monoxide gas that is produced by the resulting reaction is precipitated on a precipitation substrate and condensed, so that the vapor deposition material is produced. This manufacturing method is called a vacuum condensation method.

Since the silicon monoxide vapor deposition material that is manufactured by the vacuum condensation method is manufactured by an extensive manufacturing process, this material is expensive; furthermore, the following problem also arises: namely, the composition of the material in the direction of thickness is not uniform.

To describe this in detail, there is no problem in the vicinity of the surface of the vapor deposition material that is finally precipitated on the precipitation substrate; however, the portion that is initially precipitated on the precipitation substrate has a needle-form composition, and when this portion is formed into a film as a vapor deposition material on the surface of another film, the phenomenon of splash occurs extensively, so that the following problem arises: namely, defects such as pinholes and the like are generated in the silicon monoxide vapor deposition film that is obtained, so that the permeation resistance deteriorates.

### DISCLOSURE OF THE INVENTION

It is an object of the present invention to provide a silicon monoxide vapor deposition material with a constitution that tends not to generate splash when this material is formed as a film on the surface of another film (in a silicon monoxide vapor deposition material that is manufactured by the vacuum condensation method), and a method for the production thereof.

The present inventor conducted various studies concerning the properties and compositions of silicon monoxide vapor deposition materials that can suppress the occurrence of splash in the formation of a silicon monoxide vapor deposition film. As a result, the inventor discovered that the brittleness of the material itself has a great effect on the phenomenon of splash. Furthermore, as a result of diligent research with reference to the brittleness of such materials that tend not to generate splash, the inventor applied the rattler test used for the evaluation of pressed powders to silicon monoxide vapor deposition materials, and discovered that the occurrence of splash can be suppressed in cases where such materials have a specified rate of resistance to weight reduction (rattler value).

Furthermore, in the present invention, the rattler value was measured by the method described in the standard "JPMA P11-1992 Metal Pressed Powder Rattler Value Measurement Method" of the Japanese Powder-Forged Metal Association (JPMA).

Furthermore, as a result of various studies concerning methods for producing a silicon monoxide vapor deposition material that has a specified rattler value, the present inventor discovered that the silicon monoxide vapor deposition material that has a specified rattler value can be stably obtained, and that the object of the present invention can be achieved, by forming the inner circumferential surface of the cylindrical tube used as a substrate for precipitation and condensation during the rise of the vapor deposition material that is heated and sublimated in a convention vacuum condensation process as a specified inclined inner circumferential surface that is formed so that the internal diameter of the upper part of the cylindrical tube is smaller than the internal diameter of the lower part, and precipitating and condensing the sublimated material on this inner circumferential surface. This discovery led to the perfection of the present invention.

Specifically, the present invention is a silicon monoxide vapor deposition material produced by the vacuum condensation method, characterized in that this vapor deposition material has a rattler test weight reduction rate (rattler value) of 1.0% or less.

Furthermore, the present invention is a method for producing a silicon monoxide vapor deposition material, characterized in that when a silicon monoxide vapor deposition material is obtained by condensing a vapor raw material produced by heating and sublimating a specified raw material on a tubular inner circumferential surface used as a precipitation substrate, a precipitation substrate in which the inner circumferential wall of the tube is formed as an inclined inner circumferential surface which is inclined, for example, by 1 to 45 degrees with respect to a vertical line, so that the upper part of the tubular body has a reduced diameter, is used.

### BRIEF DESCRIPTION OF THE DRAWINGS

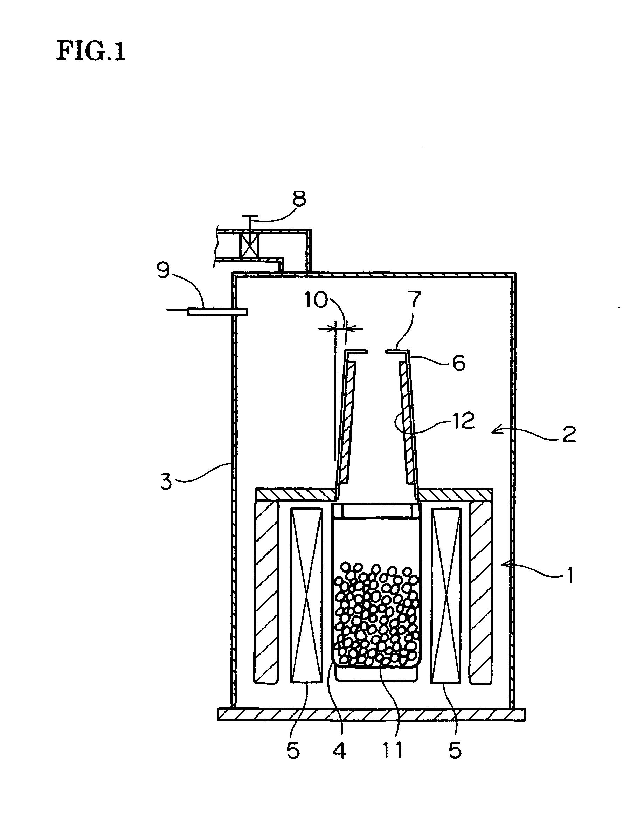

Fig. 1 is an explanatory diagram which shows one example of the manufacturing apparatus used in the method of the present invention for producing a silicon monoxide vapor deposition material.

### BEST MODE FOR CARRYING OUT THE INVENTION

The method of the present invention for producing a silicon monoxide vapor deposition material will be described in detail on the basis of the example of the manufacturing apparatus shown in Fig. 1. This apparatus has a construction in which a precipitation chamber 2 is mounted on top of a raw material chamber 1, and the apparatus is disposed inside a vacuum chamber 3.

Here, the raw material chamber 1 consists of a cylindrical body; a raw material vessel 4 which comprises a cylindrical tube with a bottom is inserted and disposed in the center of this raw material chamber 1. A heating source 5 comprising (for example) an electric heater is disposed around this raw material chamber 1, and silicon monoxide gas produced by a process of sublimation and reaction caused by the heating source 5 rises from the open upper end of the raw material chamber 1. The precipitation chamber 2 is provided in order to cause precipitation of the silicon monoxide gas that is sublimated in the raw material chamber 1; the sublimated gas component rises and passes through the interior of a precipitation substrate 6 that is disposed on the raw material vessel 4 of the raw material chamber 1 so that this substrate 6 communicates with the open upper end opening.

The precipitation substrate 6 comprises a truncated conical tube or a truncated pyramidal tube made of stainless steel. Specifically, the precipitation substrate 6 has a shape in which the upper end side is constricted so that internal diameter of the upper end of an ordinary cylindrical tube or angular tube is smaller than the internal diameter of the lower end. The inner circumferential surface that is used to cause precipitation of the sublimated silicon monoxide gas forms an inclined surface that is inclined by a specified angle with respect to a vertical line. Furthermore, a lid 7 which has a hole opened in the center is installed so that this lid 7 can be freely attached to or removed from the upper end of the substrate.

The precipitation substrate 6 was described using an integral tubular body as an example. However, this precipitation substrate need not necessarily be an integral type substrate; this substrate may also be a segmented type substrate that is segmented into an arbitrary number of parts. Furthermore, it is not absolutely necessary that all of the inner circumferential surface be an inclined surface, or that this inner circumferential surface be continuous in the circumferential direction; for example, in the case of a polygonal tube, there may be gaps between the adjacent inclined surfaces at the corner parts. Furthermore, a construction may also be used in which a segmented type tubular body that has an inclined inner circumferential surface according to the present invention is disposed and supported inside another ordinary tubular body.

In the present invention, the reason that the inner circumferential surface of the precipitation substrate 6 is formed as a specified inclined surface is as follows: namely, this is done in order to obtain a high-quality silicon monoxide vapor deposition material that suppresses the occurrence of splash, i. e., a silicon monoxide vapor deposition material that has a rattler test weight reduction rate (rattler value) of 1.0% or less.

As a result of various experiments conducted by the present inventor, it was confirmed that the occurrence of splash can be suppressed by satisfying the rattler value requirement. It is inferred that even in the case of a slight inclination of 1 degree, the radiant heat on the precipitation substrate from the raw material chamber varies, so that a variation also occurs in the gas convection currents in the precipitation chamber, the temperature distribution of the precipitation substrate and the like, thus satisfying the rattler value requirement so that the occurrence of splash is suppressed; however, the detail reasons for this effect are unclear.

Furthermore, if this inclination angle exceeds 45 degrees, the frequency with which the silicon monoxide precipitation layer that is precipitated peels from the precipitation substrate increases; accordingly, in order to obtain a homogeneous silicon monoxide vapor deposition material with a uniform overall thickness, it is desirable to set the inclination of the precipitation substrate in the range of 1 degree to 45 degrees. A range of 2 degrees or greater, or 2 to 20 degrees, is even more desirable.

If the pressure inside the precipitation chamber 2 that is disposed inside the vacuum chamber 3 exceeds 40 Pa, the surface of the precipitated silicon monoxide precipitation layer will be formed as a surface with indentations and projections; accordingly, such a high pressure is undesirable. On the other hand, if this pressure is less than 7 Pa, the fine and dense texture of the precipitation layer will drop; accordingly, such a low pressure is also undesirable. The reason that the state of the precipitation layer varies conspicuously according to the pressure is unclear; however, at pressures outside the range of 7 Pa to 40 Pa, the rattler value is not reduced to 1.0 or less, so that the occurrence of splash during the formation of the silicon monoxide vapor deposition film cannot be sufficiently suppressed.

In the present invention, the pressure control means in the precipitation chamber 2 may be any universally known control means or device performing control ranging from simple control to mass flow control that controls the valve of the vacuum pump so that a specified pressure range is maintained in accordance with a vacuum gauge inside the chamber.

In the manufacturing apparatus using the vacuum condensation method of the present invention, any universally known means may be used as the construction of the apparatus other than the characterizing precipitation substrate that has the shape of a truncated conical tube or truncated pyramidal tube (e. g., for the heating source); furthermore, in regard to the construction relating to the vacuum chamber and the like, any universally known construction may be used.

### Embodiments

Here, as the raw material placed in the raw material vessel 4 of the manufacturing apparatus shown in Fig. 1, powdered silicon (mean particle size 10 µm or less) obtained by mechanically pulverizing a semiconductor device silicon wafer, and commercially marketed powdered silicon dioxide (mean particle size 10 µm or less) were mixed in specified proportions, and this mixture was subjected to wet granulation using pure water, after which the granulated raw material was dried and used as a mixed raw material.

The mixed raw material 11 was placed into the raw material vessel 4 of the raw material chamber 1, and the vacuum chamber 3 was exhausted to a vacuum atmosphere at a pressure of 40 Pa, 25 Pa, 10 Pa or 7 Pa using the exhaust valve 8 of the vacuum chamber 3. Then, after the specified pressure was confirmed by the pressure gauge 9, power was supplied to the heating source 5 of the raw material chamber 1 so that the interior of the raw material chamber 1 was heated. A reaction was performed by maintaining the temperature at a specified temperature in the range of 1100 to 1350°C for a specified time of approximately 1 hour or longer, thus producing a silicon monoxide gas.

The silicon monoxide gas thus produced rose from the raw material chamber 1 and entered the precipitation chamber 2; this gas was then precipitated on the inner circumferential wall of the precipitation substrate (inclined at an angle of 1 degree to 45 degrees), which was preheated to a temperature of 300 to 800°C. The silicon monoxide precipitation layer that was precipitated on the precipitation substrate 6 was uniformly precipitated at the same thickness over the entire substrate 6.

Furthermore, for purposes of comparison, a silicon monoxide gas was precipitated with the inclination of the precipitation substrate set at 60 degrees, 10 degrees or 0 degrees (conventional precipitation substrate) in a vacuum atmosphere at a pressure of 60 Pa, 40 Pa, 25 Pa or 5 Pa using the same mixed raw material as in the abovementioned embodiments of the present invention.

The weight reduction rate was measured by the rattler test for the respective silicon monoxide vapor deposition materials manufactured under the abovementioned conditions.

Furthermore, silicon monoxide vapor deposition films were manufactured by means of a resistance heating vapor deposition apparatus using the silicon monoxide vapor deposition materials thus obtained. Moreover, the conditions of splash generation during the formation of the silicon monoxide vapor deposition films were observed. The rattler values and conditions of splash generation are shown in Table 1.

It is seen from the results shown in Table 1 that Embodiments 1 through 13 of the present invention all showed a rattler value of 1.0 or less, and that there was little occurrence of splash during the formation of the silicon monoxide films. In particular, in embodiments in which the pressure was lowered to a value of 10 to 25 Pa, and the inclination of the precipitation substrate was set at 2 degrees or greater, even lower rattler values were obtained, and there was extremely little occurrence of splash during the formation of the silicon monoxide vapor deposition films.

On the other hand, Comparative Example 1 was a conventional embodiment in which a precipitation substrate with no inclination was used in the vacuum vapor deposition method; in this case, the rattler value was high, i. e., 2.0%, and extensive splash was seen during the formation of the silicon monoxide vapor deposition film.

Likewise, in the case of Comparative Example 2, in which the pressure was set at 60 Pa even though an inclined precipitation substrate was used, extensive splash was seen. In Comparative Examples 4 and 6, in which the condition of a pressure of 40 Pa or less was satisfied, but in which a precipitation substrate with an inclination of 60 degrees was used, the precipitated silicon monoxide precipitation layer peeled away, so that testing could not be performed. Furthermore, in the case of Comparative Example 5, in which a precipitation substrate with no inclination was used in a state where the pressure was low (25 Pa), the occurrence of splash was extensive, and in the case of Comparative Example 7, in which the pressure was lowered to 5 Pa while a precipitation substrate with an inclination of 10 degrees was used, the precipitation layer was brittle, and the occurrence of splash was extensive.

It is seen from the test results obtained for these comparative examples that the occurrence of splash during the formation of a silicon monoxide vapor deposition film can be suppressed if the inclination of the precipitation substrate is 1 to 45 degrees, and (even more preferably) if the pressure inside the precipitation chamber is 7 to 40 Pa.

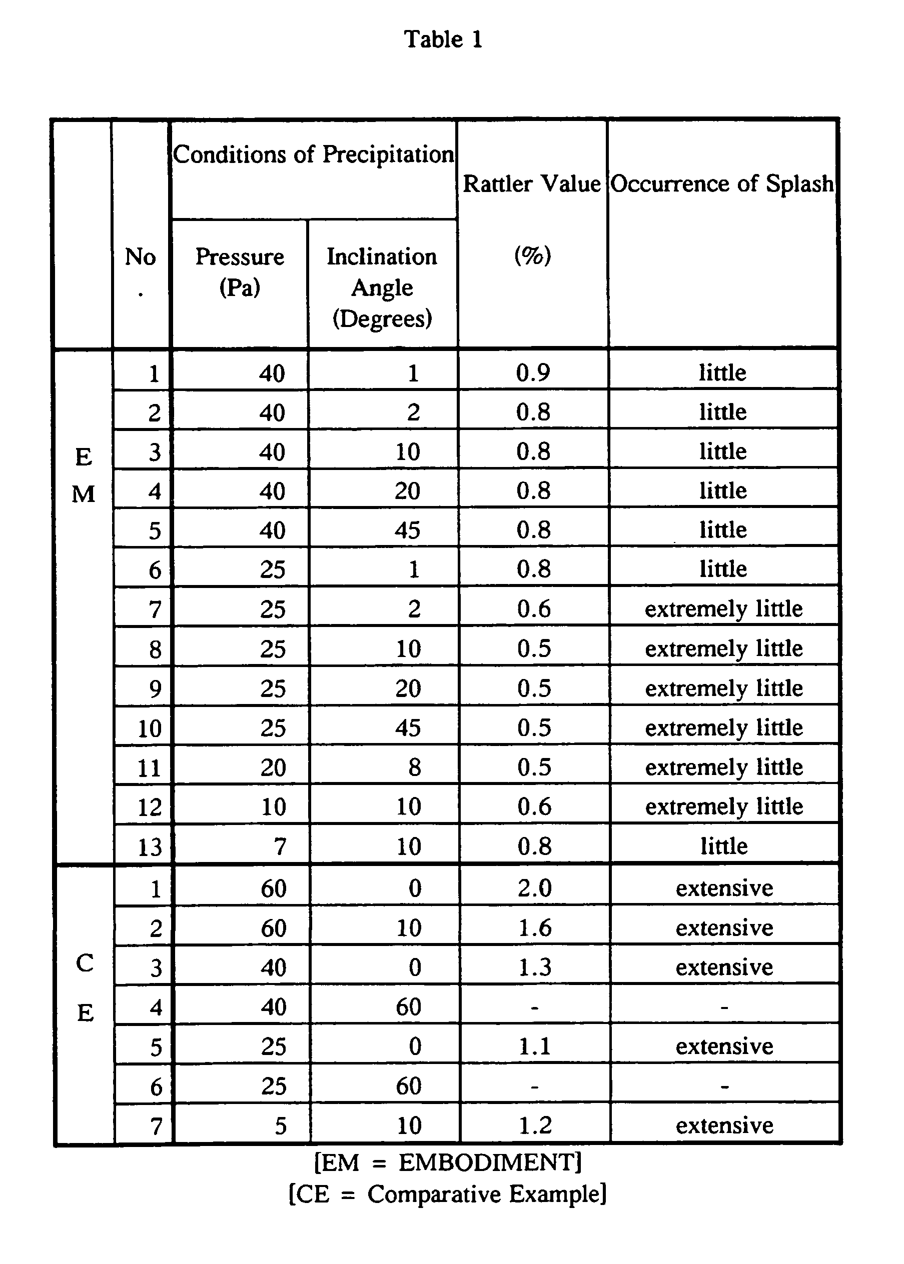

### INDUSTRIAL APPLICABILITY

The present invention makes it possible to obtain a silicon monoxide vapor deposition film which tends not to generate splash during film formation on another film, and which is superior in terms of resistance to permeation, by causing a silicon monoxide vapor deposition material produced by the vacuum condensation method to have a rattler test weight reduction rate (rattler value) of 1.0% or less.

In the present invention, the silicon monoxide vapor deposition material with a rattler value of 1.0% or less can be stably mass-produced by using a precipitation substrate that comprises an integral truncated conical tube or truncated pyramidal tube, or a segmented truncated conical tube or truncated pyramidal tube, during the manufacture of the silicon monoxide vapor deposition material by the vacuum condensation method.

In the present invention, a silicon monoxide vapor deposition material in which the rattler value is even smaller, and which shows conspicuously reduced splash during film formation, can be manufactured by controlling the pressure inside the precipitation substrate to a value of 7 Pa to 40 Pa during manufacture by the abovementioned vacuum condensation method.

## Claims

1. A silicon monoxide vapor deposition material produced by the vacuum condensation method, which has a rattler test weight reduction rate (rattler value) of 1.0% or less.

2. A method for producing a silicon monoxide vapor deposition material, wherein a precipitation substrate comprising a tubular body whose inner circumferential wall is formed as an inclined surface that is inclined by 1 to 45 degrees relative to a vertical line so that the internal diameter on the side of the upper part of the tubular body is smaller than the internal diameter on the side of the lower part thereof is used when the silicon monoxide vapor deposition material is produced by precipitating and condensing a vapor raw material, formed by heating and sublimating a raw material, on the surface of the precipitation substrate, and the vapor raw material is precipitated and condensed on the inclined inner circumferential surface, the atmosphere inside the precipitation substrate being a vacuum atmosphere at a pressure of 7 Pa to 40 Pa.

3. The method for producing a silicon monoxide vapor deposition material according to claim 2, wherein the inner circumferential wall of the precipitation substrate in which the inner circumferential wall of the tube is formed as an inclined surface is segmented.

## Patentansprüche

1. Siliziummonixidmaterial zur Aufdampfung, welches durch das Vakuumkondensationsverfahren erzeugt wird und eine Rattler-Testgewichtverringerungsrate (Rattler-Wert) von 1,0% oder weniger aufweist.

2. Verfahren zur Herstellung eines Siliziummonixidmaterials zur Aufdampfung,
wobei ein Niederschlagssubstrat, welches einen rohrförmigen Körper aufweist, dessen innere Umfangswand als eine geneigte Oberfläche ausgebildet ist, die um 1 bis 45 Grad im Verhältnis zu einer Vertikallinie geneigt ist, so dass der Innendurchmesser auf der Seite des oberen Teiles des rohrförmigen Körpers kleiner als der Innendurchmesser auf der Seite des unteren Teiles davon ist, verwendet wird, wenn das Siliziummonixidmaterial zur Aufdampfung durch Niederschlagen und Kondensieren eines Rohmaterials erzeugt wird, welches durch Erhitzen und Sublimieren eines Rohmaterials auf der Oberfläche des Niederschlagssubstrates ausgebildet wird, wobei das Dampfrohmaterial auf der geneigten inneren Umfangsfläche niedergeschlagen und kondensiert wird, und wobei die Atmosphäre innerhalb des Niederschlagssubstrates eine Vakuumatmosphäre mit einem Druck von 7 Pa bis 40 Pa ist.

3. Verfahren zur Herstellung eines Siliziummonixidmaterials zur Aufdampfung nach Anspruch 2,
wobei die innere Umfangswand des Niederschlagssubstrates, bei dem die innere Umfangswand des Rohres als eine geneigte Oberfläche ausgebildet ist, segmentiert wird.

## Revendications

1. Un matériau de monoxyde de silicium pour dépôt par évaporation sous vide produit par la méthode de condensation sous vide, qui a un taux de réduction du poids mesuré par essai rattler (valeur rattler) de 1,0% ou moins.

2. Une méthode de production d'un matériau de monoxyde de silicium pour dépôt par évaporation sous vide, au cours de laquelle on utilise un substrat de précipitation comprenant un corps tubulaire, dont la paroi intérieure circonférentielle forme une surface inclinée qui est inclinée de 1 à 45 degrés par rapport à une ligne verticale, de manière à ce que le diamètre intérieur du côté de la partie supérieure du corps tubulaire est plus petit que le diamètre intérieur du côté de sa partie inférieure, le substrat de précipitation étant utilisé lorsque le matériau de monoxyde de silicium pour dépôt par évaporation sous vide est produit en précipitant et en condensant, sur la surface du substrat de précipitation, la vapeur d'un matériau brut formé en chauffant et en sublimant un matériau brut, et au cours de laquelle la vapeur du matériau brut est précipitée et condensée sur la surface intérieure circonférentielle inclinée, l'atmosphère à l'intérieur du substrat de précipitation étant une atmosphère sous vide à une pression de 7 Pa à 40 Pa.

3. La méthode de production d'un matériau de monoxyde de silicium pour dépôt par évaporation sous vide selon la revendication 2, dans laquelle la paroi intérieure circonférentielle du substrat de précipitation, dans lequel la paroi intérieure circonférentielle du tube forme une surface inclinée, est segmentée.
